# EUROPÄISCHE PATENTSCHRIFT

(11) **EP 2 003 460 B1**
(45) Veröffentlichungstag und Bekanntmachung des Hinweises auf die Patenterteilung: **21.09.2011**
(21) Anmeldenummer: 08010224.7
(22) Anmeldetag: 05.06.2008
(51) Int. Cl.: G01R 31/28, G01R 1/073, G01R 1/067

(54) **Nadelkartenanordnung**
Pin card assembly
Agencement de carte d'aiguille

(30) Priorität: 11.06.2007 DE 102007027380
(43) Veröffentlichungstag der Anmeldung: 17.12.2008
(73) Patentinhaber: Micronas GmbH, 79108 Freiburg (DE)
(72) Erfinder: Stiefvater, Günter, 79295 Sulzburg (DE); Hauser, Wolfgang, 79346 Endingen (DE)
(74) Vertreter: Koch Müller Patentanwaltsgesellschaft mbH

(56) Entgegenhaltungen:
- EP-A- 1 717 590
- WO-A-2006/113708
- US-A1- 2006 043 984
- US-A1- 2007 089 551

## Beschreibung

Die Erfindung bezieht sich auf eine Nadelkartenanordnung mit einem PCB, welches in einem Stiffener befestigt ist.

Eine solche Nadelkartenanordnung ist z.B. aus WO 2006/113708 A2 bekannt.

Zum Prüfen von Wafern wird eine Nadelkartenanordnung verwendet, welche eine befestigte Nadelkarte aufweist. Die Nadelkarte besteht üblicherweise aus einem PCB (printed circuit board / gedruckte Leiterplatte), einem Spider (Nadelspinne) und einem Stiffener. Das PCB ist in der als Stiffener bezeichneten Rahmenanordnung in Form eines Versteifungsrings befestigt. Zentral in der Anordnung sind Nadeln angeordnet, welche mit einem bestimmten Overdrive (Übersteuerung) von insbesondere 30 - 70 µm gegen eine Waferoberfläche eines zu testenden Wafers gedrückt werden.

Beim Wafertest des Wafers wird mittels einer heiz- und oder kühlbaren Waferaufnahme, welche als Chuck bezeichnet wird, der Wafer unterhalb des PCBs gelagert und auf eine Testtemperatur gebracht. Dabei ändert sich auch die Temperatur der Unterseite des PCBs gegenüber der Oberseite ständig. Dies hat eine wechselnde Durchbiegung des PCBs zur Folge. Die Kraft dieser Durchbiegung ist so stark, dass auch der Stiffener, der mit dem PCB fest verschraubt ist, elastisch verformt wird. Durch die Verformung wandern die Kontaktnadeln, die an dem PCB oder an dem Stiffener befestigt sind, ständig in einer Richtung senkrecht zur Lagerungsebene des Wafers und der Nadelkartenanordnung.

Ein Testen im Waferrandbereich oder ein kurzer Stop für die Nadelreinigung hat eine Änderung des Kontaktierdruckes der Nadeln zur Folge. Änderungen von ca. 10 µm können entscheidend sein, ob ein gemessenes Produkt als gut oder als schlecht zu bewerten ist.

Bei der solchen Nadelkartenanordnungen müssen beim Wafertest eines Wafers bestimmte Vorheizzeiten eingehalten werden, um überhaupt testen zu können. Solche Vorheizzeiten sind erforderlich nach dem Laden eines Wafers, nach dem Ausrichten des geladenen Wafers und außerdem sehr lange nach einem Nadelkartenwechsel. Dies bedingt eine lange Zyklusdauer beim Wafertest und einen entsprechend geringen Durchsatz. Selbst unter Einhaltung solcher Vorheizzeiten besteht noch die Gefahr von fehlerhaften Messungen aufgrund einer Durchbiegung auch des Stiffeners.

Die Aufgabe der Erfindung besteht darin, eine Nadelkartenanordnung zur PCB-Befestigung vorzuschlagen, welche bei Temperaturänderungen eine bessere Kompensation unerwünschter Einflüsse aufgrund von zu starken Durchbiegungen ermöglicht. Insbesondere soll eine geringere oder gar keine Durchbiegung des Stiffeners ermöglicht werden.

Diese Aufgabe wird durch eine Nadelkartenanordnung mit den Merkmalen des Patentanspruchs 1 gelöst. Vorteilhafte Ausgestaltungen sind Gegenstand von abhängigen Ansprüchen.

Bevorzugt wird demgemäß eine Nadelkartenanordnung zur PCB-Befestigung mit einem Stiffener, mit einem im Stiffener angeordneten PCB und mit einem vom Stiffener feststehend gehaltenen Spider mit zumindest einer Nadel zum Testen eines Wafers, wobei das PCB lose entkoppelt am Stiffener gelagert ist.

Die Verbindungen der Nadeln zum Anschlusspunkt am PCB dürfen nicht stramm sondern zum Ausgleichen einer Verbiegung des PCBs in einem bogenförmigen Verlauf verlegt werden.

Gemäß einer ersten Ausführungsform sind zwischen dem PCB und dem Stiffener mehrere Schrauben mit Abstanzhalter eingesetzt. Bevorzugt sind Abstandshalter als Distanzhülsen ausgebildet, die wie eine Ansatzschraube funktionieren.

Die Befestigungselemente sind vorzugsweise jeweils als Schrauben ausgebildet.

Gemäß einer mit der ersten kombinierbaren zweiten Ausführungsform sind solche Befestigungselemente am Stiffener befestigt oder als Element des Stiffeners ausgebildet, wobei die Befestigungselemente einen Abschnitt des PCBs hintergreift. Solche Befestigungselemente können als Lasche oder Haken ausgebildet sein.

Ein Kerngedanke der technischen Umsetzung besteht somit darin, dass das PCB bei der Montage und im späteren Betrieb vom Stiffener mechanisch entkoppelt ist. Dies wird insbesondere durch eine schwimmende Lagerung ermöglicht.

Die Senkungen der Bohrungen im PCB wurden gemäß einer besonders bevorzugten Ausführungsform so modifiziert, dass mittels Distanzhülsen oder Ansatzschrauben das PCB mit etwas mechanischem Spiel in allen Richtungen gehalten wird. Das Spiel ist dabei so groß, dass die Ausdehnungen und Durchbiegungen möglichst keine mechanische Kräfte auf den Stiffener übertragen. Zentriert wird das PCB weiterhin durch zwei Passstifte.

Das Montageprinzip kann alternativ oder zusätzlich auch durch unterlegte oder unter den Schraubenkopf von Schrauben zur Befestigung gelegte weiche Materialien erreicht werden.

Wenn durch einen Testkopf und dessen Pogo Pins (Federkontaktstifte) kein Druck auf das PCB ausgeübt wird, kann auf solche Schrauben zur Befestigung verzichtet werden. In einem solchen Fall wird das PCB relativ zum Stiffener z.B. mit Klauen oder durch bestimmte hintergreifende oder ineinander eingreifende Formen des PCBs und/oder des Stiffeners gehalten.

Eine weitere vorteilhafte Ausgestaltung sieht vor, den Stiffener wie eine Brücke auszuarbeiten bzw. auszugestalten. Dies ist insbesondere dann vorteilhaft, wenn keine Drücke durch Federkontaktstifte aufzunehmen sind.

Ein Ausführungsbeispiel wird nachfolgend anhand der Zeichnung näher erläutert. Es zeigen:
- Fig. 1: in Schnittansicht eine Nadelkarten-Anordnung oberhalb eines Chucks mit einem kontaktierten Wafer in einer ersten Betriebsstellung bei eine Chucktemperatur > 40Grad Celsius,
- Fig. 2: die Anordnung gemäß Fig. 1 in einer zweiten Betriebs-stellung bei einer Chucktemperatur < 10 Grad Celsius und
- Fig. 3: eine Draufsicht auf die Anordnung gemäß Fig. 1.

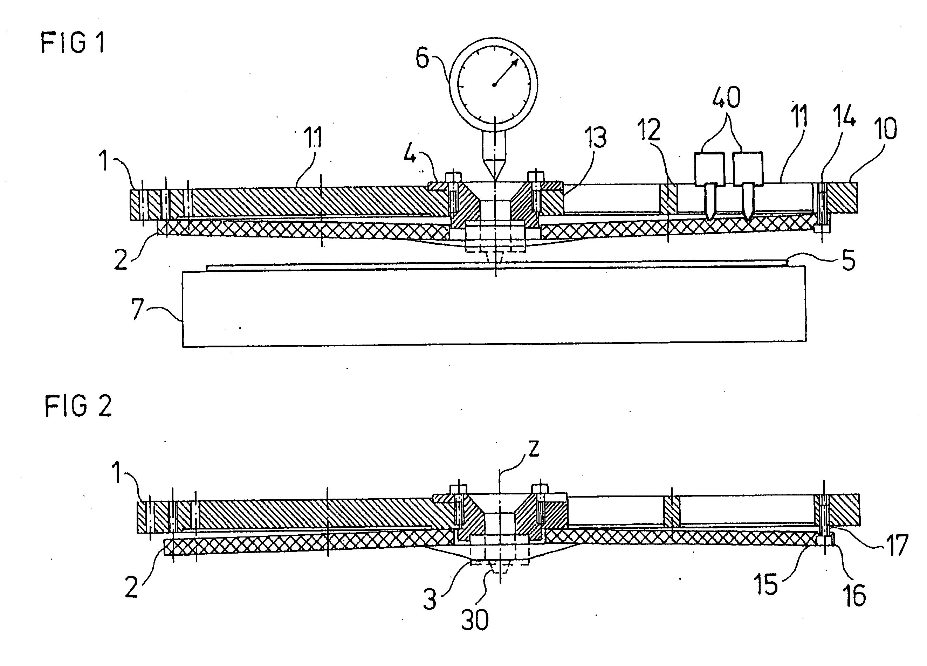

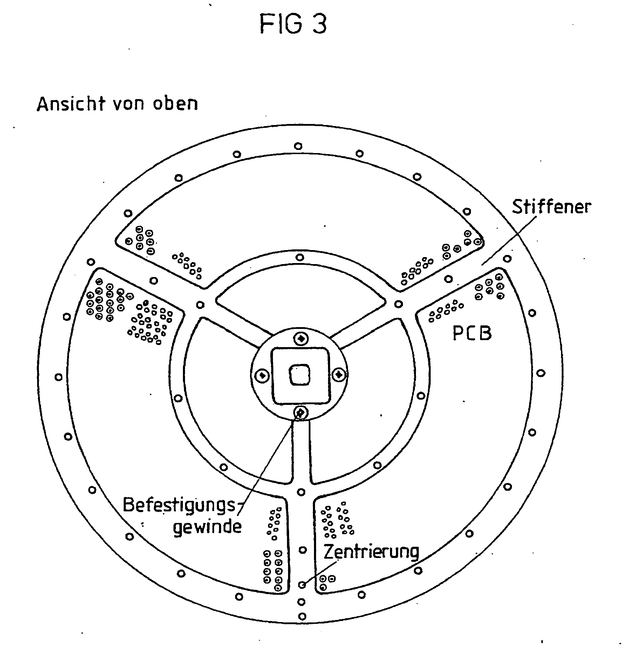

Wie dies aus den Figuren 1 bis 3 ersichtlich ist, besteht eine Nadelkarten-Anordnung bzw. eine Nadelkarte im Wesentlichen aus einem Stiffener 1, an welchem eine gedruckte Leiterplatte, welche nachfolgend als PCB (Printed Circuit Board) 2 bezeichnet wird, gelagert ist. Zentral in dem Stiffener 1 und dem PCB ist ein Nadelspinne 3, der auch als Spider bezeichnet wird, über eine Nadelspinnenhalterung 4 gelagert. Stirnseitig, das heißt zentral in Richtung z eines Wafers 5, sind am Spider 3 eine oder mehrere Nadeln 30 angeordnet. Der Wafer 5 liegt auf einem Chuck 7, über welchen der Wafer 5 auf eine oder mehrere zum Testen gewünschte Temperaturen gebracht wird.. Mittels einer rückseitig der Nadelspinnenhalterung 4 angeordneten und nur symbolisch skizzierten Messeinrichtung 6 können Z-Höhenschwankungen des Spiders 3, durch Temperaturänderungen an der PCB Unterseite, erfasst werden.

Bei einer derart dargestellten Anordnung gemäß Fig. 1 herrscht eine Testtemperatur größer einer Umgebungstemperatur, wobei die Testtemperatur=(Chucktemperatur) in einem Bereich von typischerweise aber nicht zwingend notwendig 30°C - 200°C liegt. Fig. 2 zeigt den Fall bei einer Chuck-Temperatur < 20°C bis - 55°C
Der Stiffener 1 ist als ein Rahmen, insbesondere Versteifungsring, in üblicher Art und Weise ausgebildet und besteht aus einem außenseitigen Ring 10, in welchem weitere Ringe 12, 13 über Querverstrebungen 11 angeordnet sind. Über Gewindebohrungen 14, welche insbesondere im gesamten Bereich, d.h. in den Ringen 10, 12, 13, angeordnet sind, ist das PCB 2 mittels mehrerer Schrauben 15 befestigbar. Die Schrauben 15 führen dabei durch Bohrungen 17 im PCB 2.

In einer zentralen Durchtrittsöffnung u.a. des PCBs 2 ist der Spider 3 und die Spiderhalterung 4 aufgenommen. Die rückseitige Nadelspinnenhalterung 4 ist an dem inneren Ring 13 des Stiffeners 1 befestigt, insbesondere darin eingeschraubt.

Um einen Temperaturausgleich bzw. eine verbesserte Kompensation von Biegebewegungen aufgrund der Temperaturänderungen zu ermöglichen, dient anstelle einer starren und festen Befestigung des PCBs 2 an dem Stiffener 1 eine schwimmende Lagerung des PCBs 2 am Stiffener 1. Diese schwimmende Lagerung kann dadurch erzielt werden, dass gemäß einer besonders bevorzugten Ausführungsform des PCBs 2 diese Schrauben 15 nicht fest gegen den Stiffener 1 geschraubt sind.

Gemäß einer ersten und besonders bevorzugten Ausführungsform ist die Bohrung 17 in dem zum Stiffener 1 zugewandten Bohrungsabschnitt breit genug, um eine Distanzhülse einzusetzen, welche breiter als die Gewindebohrung 14 im Stiffener 1 ist. Dadurch besteht für das PCB 2 Spiel.

Ein Schraubenkopf 16 der Schraube 15 wird somit gegen den Stiffener 1 richtend in oder gegen den PCB 2 gespannt, wobei über die Distanzhülse 17 das PCB 2 und der Stiffener 1 in einer entspannten Stellung mit ihren einander zugewandten Flächen auf Abstand gehalten werden. Dadurch verbleibt Spiel für das PCB 1 in Richtung zum Stiffener 1 hin.

Die Anordnung der Befestigungselemente in Form der zeichnerisch einen skizzierten Schraube 15 erfolgt dabei so, dass von der Vielzahl der Schrauben, welche zusammen mit den Distanzhülsen an den Ringen 10, 12, 13 angeordnet sind, Druck von z.B. an die 500 Pogo Pins (Federkontaktstiften) 40 auf das PCB aufgenommen werden kann. Im Fall von 500 solchen Pogo Pins sind dies ca. 70 kp. Die Pogo Pins dienen dazu, elektrische Signale vom PCB zum Tester bzw. Testkopf zu führen. (Anmerkung: Mit Testkopf ist die Elektronik und Mechanik oberhalb der Nadelkarte gemeint. Der Testkopf leitet mittels Pogopins die Signale weiter zum Tester.)

Gemäß alternativer Ausführungsformen kann eine solche Wirkung auch dadurch erzielt werden, dass das PCB 2 in für sich bekannter Art und Weise direkt mit solchen Schrauben 15 an dem Stiffener 1 befestigt wird, wobei jedoch ein elastisches Element zwischen diese gespannt ist. Die Spannkraft der Schraube ist dann so gewählt, dass das PCBs 2 das elastische Element nicht fest zusammendrückt, während das PCB 2 gegen den Stiffener 10 geschraubt wird, sondern dass nur eine vorzugsweise geringe oder gar keine Vorspannung aufgebracht wird, welche das elastische Element zusammendrücken würde. Dadurch kann das elastische Element bei einer späteren Biegung des PCBs 2 aufgrund einer thermischen Einwirkung noch ausreichend zusammengedrückt werden, um kompensierend wirken zu können.

Gemäß weiterer alternativer Anordnungen, insbesondere dann, wenn durch das PCB 2 kein Druck auf den Testkopf ausgeübt wird, reicht bei manchen Applikationen auch eine außenseitig umgreifende Befestigung des PCBs 2 am Stiffener 10 mit Hilfe beispielsweise klauenartiger Befestigungsmittel.

Gemäß weiterer alternativer Ausführungsformen kann beispielsweise anstelle einer Schraube 15, welche durch eine separate Distanzhülse 17 geführt wird, direkt eine Ansatzschraube verwendet werden, welche zwischen dem Gewindeabschnitt und dem Schraubenkopf 16 einen verbreiterten Abschnitt aufweist, so dass eine ausreichende Beabstandung des Schraubenkopfs 16 von der zugewandten Oberfläche des Stiffeners 10 sichergestellt ist.

## Patentansprüche

1. Nadelkartenanordnung zur PCB-Befestigung mit
- einem Stiffener (1),
- einem im Stiffener (1) angeordneten PCB (2) und
- einem vom Stiffener und dem PCB (2) gelagerten Spider (3) mit zumindest einer Nadel (30) zum Testen eines Wafers (5), wobei das PCB (2) lose entkoppelt im Stiffener (1) gelagert ist,
**dadurch gekennzeichnet, dass** das PCB (2) am Stiffener (1) schwimmend gelagert ist derart, dass bei einer ersten Testtemperatur ein mittlerer Bereich des PBC (2) vom Stiffener (1) weiter beabstandet ist als ein äußerer Bereich des PCB (2), und dass bei einer zweiten Testtemperatur, die niedriger als die erste Testtemperatur ist, der mittlere Bereich des PCB (2) näher am Stiffener (1) liegt als der äußere Bereich des PCB (2).

2. Nadelkartenanordnung nach Anspruch 1, bei der eine Vielzahl solcher Nadeln (30) zu einem Anschlusspunkt der Nadeln hin nicht stramm sondern zum Ausgleichen einer Verbiegung des PCBs (2) in einem bogenförmigen Verlauf verlegt sind.

3. Nadelkartenanordnung nach Anspruch 1 oder 2, bei der das PCB (2) seitlich beabstandet von einem Testkopf mittels zumindest eines Befestigungselements, insbesondere einer Vielzahl von Befestigungselementen in Richtung des Stiffeners (1) fest gelagert ist, wobei zwischen dem PCB (2) und dem Stiffener (1) eine Beabstandung verbleibt.

4. Nadelkartenanordnung nach einem vorstehenden Anspruch, bei der zwischen dem zumindest einen Befestigungselement und dem Stiffener (1) ein Abstandshalter eingesetzt ist, wobei eine Öffnung, insbesondere Bohrung des PCBs (2) dimensioniert ist, den Abstandshalter ganz oder zumindest teilweise aufzunehmen.

5. Nadelkartenanordnung nach Anspruch 4, bei welcher der Abstandshalter als eine Distanzhülse (17) ausgebildet ist, welche einen Schaft einer als das Befestigungselement ausgebildeten Schraube (15) umgreift.

6. Nadelkartenanordnung nach einem der Ansprüche 3 bis 5, bei welcher das zumindest eine Befestigungselement bzw. die Befestigungselemente als Schraube (15) ausgebildet ist bzw. sind, wobei eine solche Schraube einen in Richtung des Schraubenkopfes verbreiterten Abschnitt aufweist und wobei eine entsprechende öffnung, insbesondere Bohrung des PCBs (2) dimensioniert ist, den verbreiterten Abschnitt zumindest teilweise aufzunehmen.

7. Nadelkartenanordnung nach einem der Ansprüche 3 bis 6, bei welcher solche Befestigungselemente am Stiffener befestigt oder als Element des Stiffeners ausgebildet sind und bei welcher die Befestigungselemente einen Abschnitt des PCBs (2) hintergreifen.

8. Nadelkartenanordnung nach einem vorstehenden Anspruch, bei der zwischen dem PCB (2) und dem Stiffener (1) ein elastisches Element eingesetzt ist.

9. Nadelkartenanordnung nach Anspruch 8, bei der das elastische Element in einer entspannten Stellung des PCBs (2) zwischen dem PCB (2) und dem Stiffener (1) ohne oder mit nur geringer Vorspannung eingesetzt ist.

10. Nadelkartenanordnung nach einem vorstehenden Anspruch, bei welcher der Stiffener (1) in Form einer Brücke ausgestaltet ist.

## Claims

1. Pin card arrangement for printed circuitboard fastening with
- a stiffener (1),
- a printed circuitboard (2) arranged in the stiffener (1) and
- a spider (3) which is mounted by the stiffener and the printed circuitboard (2), with at least one pin (30) for testing a wafer (5), wherein the printed circuitboard (2) is mounted in the stiffener (1) to be loosely decoupled,
**characterised in that** the printed circuitboard (2) is mounted in floating manner at the stiffener (1) such that at a first test temperature a centre region of the printed circuitboard (2) is spaced further from the stiffener (1) than an outer region of the printed circuitboard (2) and at a second test temperature lower than the first test temperature the centre region of the printed circuitboard (2) lies closer to the stiffener (1) than the outer region of the printed circuitboard (2).

2. Pin card arrangement according to claim 1, in which a plurality of such pins (30) are, for compensation for distortion of the printed circuitboard (2), disposed not tight towards a connecting point of the pins, but in a curved path.

3. Pin card arrangement according to claim 1 or 2, in which the printed circuitboard (2) is fixedly mounted at a lateral spacing from a test head by means of at least one fastening element, particularly a plurality of fastening elements in the direction of the stiffener (2), wherein a spacing is left between the printed circuitboard (2) and the stiffener (1).

4. Pin card arrangement according to any one of the preceding claims, in which a spacer is inserted between the at least one fastening element and the stiffener (1), wherein an opening, particularly a bore, of the printed circuitboard (2) is dimensioned to entirely or at least partly receive the spacer.

5. Pin card arrangement according to claim 4, in which the spacer is constructed as a spacer sleeve (17) which engages around a shank of a screw (15) constructed as the fastening element.

6. Pin card arrangement according to any one of claims 3 to 5, in which the at least one fastening element or the fastening elements is or are constructed as a screw (15), wherein such a screw has a section widened in the direction of the screw head and wherein a corresponding opening, particularly a bore, of the printed circuitboard (2) is dimensioned to receive the widened section at least in part.

7. Pin card arrangement according to any one of claims 3 to 6, in which such fastening elements are fastened to the stiffener or constructed as an element of the stiffener and in which the fastening elements engage behind a section of the printed circuitboard (2).

8. Pin card arrangement according to any one of the preceding claims, in which a resilient element is inserted between the printed circuitboard (2) and the stiffener (1).

9. Pin card arrangement according to claim 8, in which the resilient element in a relaxed setting of the printed circuitboard (2) is inserted between the printed circuitboard (2) and the stiffener (1) without a bias or with only a small bias.

10. Pin card arrangement according to any one of the preceding claims, in which the stiffener (1) is designed in the form of a bridge.

## Revendications

1. Carte à aiguilles pour la fixation d'une carte de circuit imprimé PCB comprenant
un raidisseur (1)
une carte PCB (2) incorporée dans le raidisseur (1) et,
un croisillon (3) monté sur le raidisseur et la carte PCB (2) et au moins une aiguille (30) pour tester une plaquette (5), ensemble dans lequel la carte PCB (2) est montée à accouplement lâche dans le raidisseur (1) **caractérisée en ce que**
la carte PCB (2) est montée flottante sur le raidisseur (1), **en ce que** pour une première température test, la zone médiane de la carte PCB (2) est encore plus éloignée du raidisseur (1) qu'une zone extérieure de la carte PCB (2), et **en ce que** pour une deuxième température test, inférieure à la première température test, la zone médiane de la carte PCB (2) se trouve plus proche du raidisseur que la zone extérieure de la carte PCB (2).

2. Carte à aiguilles selon la revendication 1 **caractérisée en ce qu'**une pluralité de telles aiguilles (30), pour un point de connexion, ne sont pas tendues, mais déformées pour compenser une incurvation de la carte PCB (2) selon un tracé en forme d'arc.

3. Carte à aiguilles selon la revendication 1 ou 2 **caractérisée en ce qu'**un éloignement latéral à partir d'une tête de test est réalisé au moyen, au moins, d'un élément de fixation, en particulier d'une pluralité d'éléments de fixation, solidarisés dans la direction du raidisseur (1), et **en ce qu'**il reste un intervalle entre la carte PCB (2) et le raidisseur (1).

4. Carte à aiguilles selon l'une des revendications précédentes **caractérisée en ce qu'**entre l'au moins un élément de fixation et le raidisseur (1), est interposée une entretoise et **en ce qu'**une ouverture, en particulier un perçage dans la carte PCB (2) est dimensionnée de telle façon à maintenir totalement ou du moins partiellement l'entretoise.

5. Carte à aiguilles selon la revendication 4 **caractérisée en ce que** l'entretoise se présente sous la forme d'une douille, dont l'axe vient en prise périphérique avec un élément de fixation conformé en vis (15).

6. Carte à aiguilles selon l'une des revendications 3 à 5 **caractérisée en ce qu'**au moins un élément de fixation, les éléments de fixation, est ou sont réalisé(s) sous la forme de vis (15), et **en ce que** une telle vis présente en direction de sa tête une partie évasée, et **en ce qu'**est dimensionnée une ouverture correspondante, en particulier un perçage de la carte PCB (2) que la partie évasée occupe au moins partiellement.

7. Carte à aiguilles selon l'une des revendications 3 à 6 **caractérisée en ce que** de tels éléments de fixation sont réalisés fixés au raidisseur ou en tant qu'élément du raidisseur et **en ce que** les éléments de fixation viennent en prise à l'arrière d'une partie de la carte PCB (2).

8. Carte à aiguilles selon l'une des revendications précédentes **caractérisée en ce qu'**est introduit entre la carte PCB (2) et le raidisseur (1) un élément élastique.

9. Carte à aiguilles selon la revendication 8 **caractérisée en ce que** l'élément élastique est introduit dans une position détendue de la carte PCB (2) entre le raidisseur (1) et la carte (2) sans ou avec seulement peu de prétension.

10. Carte à aiguilles selon l'une des revendications précédentes **caractérisée en ce que** le raidisseur (1) est réalisé sous la forme d'un pont.
